# EUROPÄISCHE PATENTSCHRIFT

(11) **EP 1 208 598 B1**
(45) Veröffentlichungstag und Bekanntmachung des Hinweises auf die Patenterteilung: **09.01.2008**
(21) Anmeldenummer: 00947967.6
(22) Anmeldetag: 11.07.2000
(51) Int. Cl.: H01L 27/146

(54) **BILDZELLE, BILDSENSOR UND HERSTELLUNGSVERFAHREN HIERFÜR**
IMAGE CELL, IMAGE SENSOR AND PRODUCTION METHOD THEREFOR
Cellule capteur d'images, capteur d'images et procédé de fabrication correspondant

(30) Priorität: 20.07.1999 DE 19933162
(43) Veröffentlichungstag der Anmeldung: 29.05.2002
(73) Patentinhaber: INSTITUT FÜR MIKROELEKTRONIK STUTTGART, 70569 Stuttgart (DE)
(72) Erfinder: HÖFFLINGER, Bernd, D-71063 Sindelfingen (DE); GRAF, Heinz, Gerhard, D-71106 Magstadt (DE); NICKE, Markus, F-06270 Villeneuve-Loubet (FR)
(74) Vertreter: Duhme, Torsten
(86) Internationale Anmeldenummer: PCT/EP2000/006557
(87) Internationale Veröffentlichungsnummer: WO 2001/006566

(56) Entgegenhaltungen:
- EP-A- 0 883 187
- EP-A- 0 917 206
- WO-A-00/00994
- US-A- 5 898 196
- US-A- 6 023 081
- PATENT ABSTRACTS OF JAPAN vol. 1999, no. 03, 31. März 1999 (1999-03-31) -& JP 10 335622 A (CANON INC), 18. Dezember 1998 (1998-12-18) & US 6 150 682 A (CANON INC) 21. November 2000 (2000-11-21)
- PATENT ABSTRACTS OF JAPAN vol. 1997, no. 06, 30. Juni 1997 (1997-06-30) -& JP 09 051085 A (CANON INC), 18. Februar 1997 (1997-02-18)
- WONG H -S P ET AL: "CMOS ACTIVE PIXEL IMAGE SENSORS FABRICATED USING A 1.8-V, 0.25-MUM CMOS TECHNOLOGY" IEEE TRANSACTIONS ON ELECTRON DEVICES,US,IEEE INC. NEW YORK, Bd. 45, Nr. 4, 1. April 1998 (1998-04-01), Seiten 889-893, XP000753391 ISSN: 0018-9383

## Beschreibung

Die Erfindung betrifft eine in Halbleitertechnik aufgebaute Bildzelle zur Umwandlung von auf eine Oberfläche der Bildzelle auftreffender elektromagnetischer Strahlung in ein elektrisches Signal, mit einem Substrat, das eine erste Dotierung aufweist und das in mehrere aneinander angrenzende Bereiche mit unterschiedlicher Dotierung unterteilt ist, wobei die Bereiche ein strahlungssensitives Element und ein Halbleiterbauelement bilden, wobei das strahlungssensitive Element einen oberflächennahen ersten Bereich und einen oberflächenfernen zweiten Bereich aufweist, wobei der zweite Bereich dotiert ist und an den ersten Bereich angrenzt, und wobei das Halbleiterbauelement wenigstens einen oberflächennahen, dotierten dritten Bereich und einen oberflächenfernen, dotierten vierten Bereich aufweist, wobei die Ausdehnung des zweiten Bereichs in der zur Oberfläche senkrechten Richtung größer ist als die entsprechende Ausdehnung des vierten Bereichs, und wobei der vierte Bereich wenigstens teilweise in den zweiten Bereich eingebettet ist und eine höhere gleichartige Dotierung als der zweite Bereich aufweist.

Die Erfindung betrifft außerdem ein Verfahren zur Herstellung einer Bildzelle mit folgenden Schritten:
a) Bereitstellen eines Halbleitersubstrats mit einer ersten Dotierung,
b) Erzeugen eines oberflächenfernen dotierten zweiten Bereichs im Halbleitersubstrat,
c) Erzeugen eines oberflächenfernen, dotierten vierten Bereichs,
d) Erzeugen eines oberflächennahen ersten Bereichs, der an den zweiten Bereich angrenzt,
e) Erzeugen eines oberflächennahen dotierten dritten Bereichs, der an den vierten Bereich angrenzt,
f) wobei der erste und zweite Bereich derart erzeugt werden, daß sie ein strahlungssensitives Element bilden,
g) wobei der dritte und vierte Bereich derart erzeugt werden, daß sie ein Halbleiterbauelement bilden,
h) wobei der vierte Bereich mit einer senkrecht zur Oberfläche kleineren Ausdehnung als die entsprechende Ausdehnung des zweiten Bereichs erzeugt wird, und
i) wobei der vierte Bereich wenigstens teilweise in den zweiten Bereich eingebettet wird und mit einer höheren gleichartigen Dotierung als der zweite Bereich erzeugt wird.

Eine solche Bildzelle und ein solches Verfahren sind aus EP 0 883 187 A1 bekannt.

Bildzellen umfassende Bildsensoren werden insbesondere in der Kamera- und Scannertechnik eingesetzt und haben die Aufgabe, elektromagnetische Strahlung in elektrische Signale umzusetzen. Sie bestehen im wesentlichen aus einer Vielzahl von rasterartig angeordneten Bildzellen, die punktweise das aufzunehmende Bild erfassen. Die von den Bildzellen erzeugten elektrischen Ausgangssignale werden meist verstärkt und analog oder digital ausgewertet.

Je kleiner die Bildzellen und je dichter diese angeordnet sind, desto größer ist die Auflösung des Bildsensors. Bildsensoren werden deswegen meist als hochintegrierte elektronische Schaltungen in MOS-Technik aufgebaut, da sich auf diese Weise besonders hohe Bauteildichten erzielen lassen. Jede Bildzelle eines solchen Bildsensors umfaßt ein strahlungssensitives Element, z.B. eine Photodiode, dem gegebenenfalls ein oder mehrere weitere Bauelemente wie Transistoren zugeordnet sind. Aufgrund ihrer hohen Empfindlichkeit haben insbesondere ladungsgekoppelte Halbleiterbauelemente (CCD, "charged coupled device") Verbreitung gefunden. Daneben sind Bildsensoren in CMOS-Technik entwickelt worden, bei denen neben den strahlungssensitiven Elementen sowohl n- als auch p-Kanal Transistoren auf einem Chip vereint sind.

Aufgrund der Weiterentwicklung der CMOS-Herstellungsverfahren werden immer höhere Integrationsdichten der CMOS-Schaltungen möglich. Es hat sich allerdings gezeigt, daß mit der Erhöhung der Integrationsdichte die Empfindlichkeit der in CMOS-Technik aufgebauten Bildzellen tendenziell abnimmt. Dies wird darauf zurückgeführt, daß bei hochintegrierten Bildzellen aufgrund der sehr flachen Dotierungsbereiche tief eindringende langwellige Strahlungsanteile keinen Beitrag zur Stromdichte im strahlungssensitiven Element leisten können. Überdies entstehen aufgrund der zunehmend dünner ausgelegten Dotierungsbereiche zunehmend Probleme mit zu großen Kapazitäten, was gleichfalls die Empfindlichkeit reduziert und darüber hinaus das Zeit- und Übersprechverhalten verschlechtert.

Bei einer Bildzelle, die aus EP 0 917 206 A1 bekannt ist, weist eine als strahlungssensitives Element verwendete Photodiode einen tiefen oberflächennahen dotierten Bereich auf, der in eine Transistorwanne eines MOS-Transistors eingebettet ist. Dieser Bereich ist leichter dotiert als die oberflächennahen dotierten Bereiche des MOS-Transistors. Die Grenzfläche zwischen dem dotierten Bereich der Photodiode und der Transistorwanne bildet den pn-Übergang der Photodiode. Aufgrund der vergleichsweise großen Tiefe des oberflächennahen Bereichs können auch langwellige Strahlungsanteile zum Photostrom beitragen, wodurch sich die Empfindlichkeit der Bildzelle erhöht.

Bei der Bildzelle aus der eingangs genannten EP 0 883 187 A1 ist der zweite Bereich eine Schicht mit einer p-Dotierung, die niedriger ist als die p-Dotierung des darunter liegenden Substrates. Insgesamt besitzt die bekannte Bildzelle daher einen Schichtaufbau, bei dem eine niedrig dotierte p-Schicht zwischen zwei höher dotierten p-Schichten angeordnet ist, nämlich dem p-Substrat und dem p+ dotierten Bereich. Auf diese Weise wird ein Potentialverlauf senkrecht zur Oberfläche der Bildzelle geschaffen, bei dem freie Ladungsträger in dem zweiten Bereich gesammelt werden. Mit Hilfe dieses Potentialverlaufs sollen Ladungsträger aus Raumbereichen unterhalb des Halbleiterbauelements zu dem strahlungssensitiven Element geführt werden, um einen erhöhten Füllfaktor zu erhalten. Der laterale Ladungsträgertransport innerhalb des zweiten Bereich kann allerdings dazu führen, dass die Trennschärfe bei einem Bildsensor mit einer Vielzahl solcher Bildzellen ungünstig beeinflusst wird.

CN 1 217 573 A, die die Priorität des erst später veröffentlichten US-Patents 6,023,081 in Anspruch nimmt, offenbart eine Bildzelle in CMOS-Technologie, bei der ein MOS-Transistor und eine Fotodiode in einer Anreicherungsschicht ausgebildet sind, die ebenfalls eine geringere gleichartige Dotierung als ein darunter liegendes Substrat aufweist. Ziel dieser Bildzelle ist es, die Tiefe des strahlungssensitiven pn-Übergangs zu vergrößern, um Licht verschiedener Wellenlängen mit einer höheren Effizienz aufzunehmen.

US 5,898,196 offenbart eine Bildzelle, bei der die Lichtempfindlichkeit im roten Wellenlängenbereich sowie das sogenannte Latch-up-Verhalten optimiert sein sollen. Die bekannte Bildzelle besitzt einen ersten oberflächennahen und einen zweiten oberflächenfernen Bereich, die einen strahlungssensitiven pn-Übergang bereitstellen. Im dargestellten Ausführungsbeispiel besitzt der oberflächennahe erste Bereich eine p+ Dotierung und der oberflächenferne zweite Bereich besitzt eine n- Dotierung. Der zweite Bereich ist in eine Epitaxieschicht mit einer niedrigen p-Dotierung eingebettet, die wiederum auf einem p+ dotierten Substrat sitzt. Der zweite Bereich bildet somit einen zweiten pn-Übergang mit der Epitaxieschicht, der aufgrund seiner Tiefe für Strahlung im roten Wellenlängenbereich empfindlich ist. Ein Halbleiterbauelement in Form eines n-Kanal-MOS-Transistors ist ebenfalls in der niedrig dotierten Epitaxieschicht ausgebildet.

Die nicht-vorveröffentlichte WO 00/00994 offenbart eine Bildzelle, bei der die sogenannte Quanteneffizienz verbessert sein soll, ohne die Dicke der Bildzelle zu beeinträchtigen. Auch die hier beschriebene Bildzelle verwendet eine Epitaxieschicht mit einer geringen p-Dotierung, die auf einem p+ Substrat angeordnet ist. Innerhalb der niedrig dosierten Epitaxieschicht ist ferner eine Transistorwanne mit einer p-Dotierung sowie daneben eine n-dotierte Schicht ausgebildet.

Vor diesem Hintergrund ist es eine Aufgabe der Erfindung, eine Bildzelle anzugeben, die auch bei sehr großer Integrationsdichte eine hohe Empfindlichkeit aufweist und vorzugsweise in CMOS-Technik herstellbar ist.

Diese Aufgabe wird nach einem Aspekt der Erfindung durch eine Bildzelle und ein Verfahren der eingangs genannten Art gelöst, bei dem der zweite Bereich die Form einer Wanne hat und eine Dotierung aufweist, die entgegengesetzt zu der ersten Dotierung des Substrates ist, so dass der zweite Bereich und das Substrat durch einen pn-Übergang voneinander getrennt sind.

Bei dieser Lösung ist der zum strahlungssensitiven Element gehörende zweite Bereich also tiefer als der vierte Bereich, der zu einem benachbarten Halbleiterbauelement gehört. Diese Entkopplung der Tiefen der oberflächenfernen Bereiche erlaubt es, die Geometrien des strahlungssensitiven und des Halbleiterbauelements optimal an deren Funktion anzupassen. Es hat sich nämlich herausgestellt, daß ein tiefer zweiter Bereich des strahlungssensitiven Elements sich besonders günstig auf die Empfindlichkeit der Bildzelle auswirkt, da sich so Raumladungszonen von mehrere Mikrometern Dicke erzeugen lassen. Außerdem verringern sich infolge des größeren Abstandes, durch den die Raumladungen im strahlungssensitiven Element getrennt sind, die parasitären Kapazitäten. Dies trägt zusätzlich zur Erhöhung der Empfindlichkeit bei; darüber hinaus verbessern sich das Zeit-und Übersprechverhalten der Bildzelle.

Es wird mit anderen Worten ermöglicht, einerseits das strahlungssensitive Element mit einem für die spektrale Empfindlichkeit optimalen Dotierungsbereich auszubilden, während andererseits die übrigen Elemente der Schaltung flacher ausgeführt sein können, etwa in 0,3 µm-CMOS-Technik oder noch kleiner.

Besonders vorteilhaft ist es, wenn der vierte Bereich wenigstens teilweise in dem zweiten Bereich eingebettet ist und eine höhere gleichartige Dotierung als der zweite Bereich aufweist. Der vierte Bereich läßt sich bei dieser Ausführung sehr einfach durch Überdotieren des zweiten Bereichs erzeugen. Der vierte Bereich kann dadurch eine Wanne, insbesondere eine Transistorwanne, bilden, die dem Halbleiterbauelement zugeordnet ist.

Vorzugsweise ist der erste Bereich komplementär zu dem zweiten Bereich dotiert, so daß der erste und der zweite Bereich den pn-Übergang einer Photodiode bilden.

Darüber hinaus ist es auch möglich, den ersten Bereich als strahlungsdurchlässige Metallschicht auszuführen, so daß der erste und der zweite Bereich eine Schottky-Diode bilden. Möglich ist außerdem, den ersten Bereich als feldinduzierte Verarmungs- und Inversionszone auszuführen, so daß ein MIS-Photoelement oder ein Photo-MOSFET entsteht.

Bei dem benachbarten Halbleiterbauelement kann es sich beispielsweise um eine normale Diode oder um eine Photodiode handeln, die besonders für kurzwellige Strahlungsanteile empfindlich sein soll. Für die Erfindung ist es jedoch nicht wesentlich, um welchen Typ von Halbleiterbauelement es sich im einzelnen handelt.

Bei einer bevorzugten Ausführung der Erfindung ist das elektronische Bauelement ein Transistor und der vierte Bereich eine Transistorwanne. Der Transistor ist dem strahlungssensitiven Element vorteilhaft als Verstärker oder als Bestandteil einer Verstärkerschaltung zugeordnet.

In zusätzlicher Weiterbildung ist oberflächennah zwischen dem Transistor und der Photodiode ein an die Transistorwanne angrenzender Kontakt angeordnet ist. Bei entsprechender Beschaltung, vorzugsweise mit dem positiven Versorgungspotential der Bildzelle, trägt dieser Kontakt zur elektrischen Isolierung der Photodiode von dem Transistor bei und ermöglicht eine genaue Festlegung der Schwellenspannung des Transistors. Außerdem wirkt der zusätzliche Kontakt der Ausbildung des sogenannten "latch-up-Effekts" entgegen. Dieser Effekt bezeichnet bei CMOS-Schaltungen das Durchschalten einer aufbaubedingten Thyristorstruktur und kann zur Zerstörung der Bildzelle führen.

Bei einer weiteren Ausführung der Erfindung ist der zweite Bereich oberflächennah mit wenigstens einem elektrischen Kontakt versehen. Ein solcher an sich bekannter Oberflächenkontakt ist besonders einfach realisierbar. In alternativer Ausführung hierzu ist vorgesehen, den zweiten Bereich an seinem oberflächenabgewandten Ende mit wenigstens einem elektrischen Kontakt zu versehen. Bei dieser alternativen Ausführung ist der Ladungsträgerfluß in der Sperrschicht des zweiten Bereichs besonders günstig, was sich vorteilhaft auf die Empfindlichkeit der Bildzelle auswirkt.

Gemäß einer anderen Ausführung der Erfindung liegt in der zur Oberfläche senkrechten Richtung die Ausdehnung des ersten Bereichs zwischen etwa 0,1 µm und 0,2 µm und die Ausdehnung des zweiten Bereichs zwischen etwa 2 µm und 3 µm. Eine derart bemessene Tiefe ist besonders geeignet für die Detektion von elektromagnetischer Strahlung im sichtbaren Spektralbereich.

In einer dazu alternativen Ausführung liegt in der zur Oberfläche senkrechten Richtung die Ausdehnung des ersten Bereichs zwischen etwa 0,8 µm und 0,9 µm und die Ausdehnung des zweiten Bereichs zwischen etwa 8 µm und 9 µm. Eine solche Bildzelle ist insbesondere für Infrarotanwendungen geeignet.

Vorzugsweise liegt bei einer Photodiode als photosensitiven Element die Dotierung des ersten Bereichs in der Größenordnung von etwa 10¹⁸ cm⁻³. Diese hohe Dotierung ermöglicht eine hohe Empfindlichkeit der Photodiode und damit der Bildzelle.

Bei einer besonders vorteilhaften Ausführung wird die Dotierung wenigstens in dem zweiten oder in dem vierten Bereich mit zunehmendem Abstand von der Oberfläche größer. Diese an sich als "retrograde Wells" bekannten dotierten Bereiche reduzieren zum einen den oben bereits angesprochenen latch-up-Effekt. Zum anderen hat sich gezeigt, daß sich dadurch eine besonders günstige Potentialverteilung in der Raumladungszone erzielen läßt.

In Weiterbildung dieser Ausführung liegt die Dotierung des zweiten Bereichs oberflächennah in der Größenordnung von etwa 10¹⁵ cm⁻³ und oberflächenfern in der Größenordnung von etwa 10¹⁸ cm⁻³. Es hat sich gezeigt, daß Bildzellen mit diesen Dotierungen besonders günstige Eigenschaften haben.

Gemäß einer weiteren vorteilhaften Ausführung ist über der Oberfläche der Bildzelle eine Mikrolinse angeordnet. Die Mikrolinse bündelt auf die Oberfläche der Bildzelle auftreffende Strahlung auf die Oberfläche der Photodiode, so daß praktisch die gesamte Strahlung zur Detektion ausgenutzt wird. Die Empfindlichkeit der Bildzelle läßt sich mit einer solchen Mikrolinse deutlich steigern.

Bei einer anderen Ausführung der Erfindung grenzt an die oberflächenferne Seite des zweiten Bereichs eine "buried layer" an. Hierbei handelt es sich um eine hochdotierte Schicht, die gut leitfähig ist und als Äquipotentialfläche dient.

Bei Bildzellen in Farbbildsensoren ist vorzugsweise über der Oberfläche der Bildzelle ein Farbfilter angeordnet, das aus der auftreffenden Strahlung einen schmalbandigen Strahlungsanteil herausfiltert.

Vorzugsweise ist außerdem über der Oberfläche der Bildzelle eine Antireflexionsschicht angeordnet. Dadurch wird weitgehend verhindert, daß auftreffende Strahlung ungenutzt an der Oberfläche der Bildzelle reflektiert wird und somit nicht in der Photodiode zur Erzeugung freier Ladungsträger beiträgt.

Es versteht sich, daß die vorstehend genannten und die nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

Weitere Merkmale und Vorteile der Erfindung ergeben sich aus der nachfolgenden Beschreibung bevorzugter Ausführungsbeispiele unter Bezugnahme auf die Zeichnung. Es zeigen:

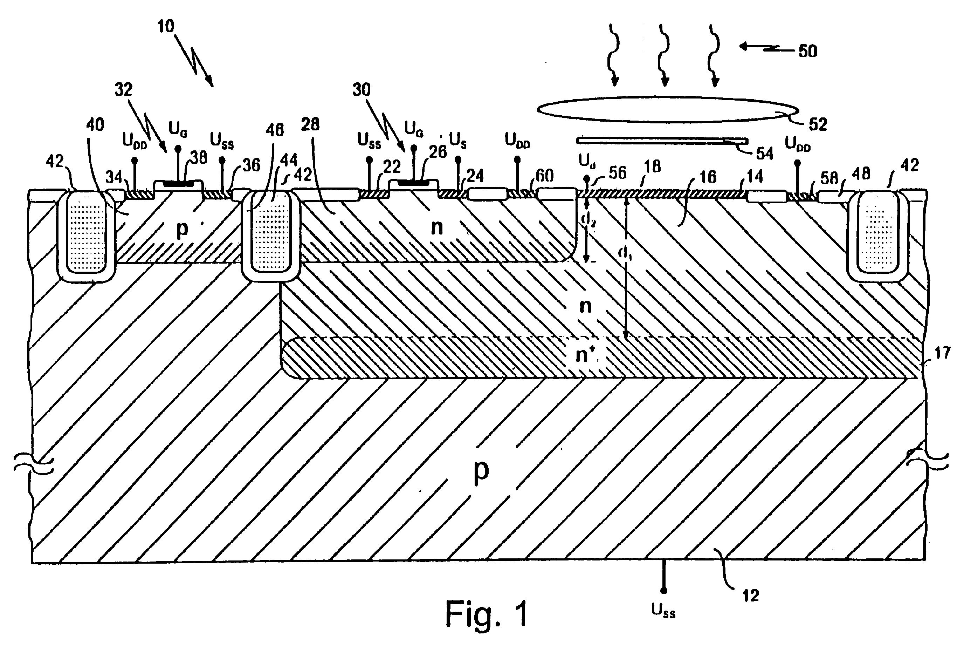

- Fig. 1: eine vereinfachte geschnittene Darstellung eines Ausführungsbeispiels einer erfindungsgemäßen Bildzelle ;

In Fig. 1 ist eine erfindungsgemäße Bildzelle insgesamt mit der Ziffer 10 bezeichnet. Die Bildzelle besteht im wesentlichen aus einem Substrat 12, bei dem es sich hier um einen schwach p-dotierten Silizium-Einkristall handelt. Das Substrat 12 ist in mehrere aneinander angrenzende Bereiche unterschiedlicher Dotierung unterteilt. Ein mit etwa 10¹⁸ cm⁻³ p-dotierter erster Bereich 14 befindet sich an der Oberfläche des Substrats 12 und grenzt an einen darunterliegenden zweiten Bereich 16 an. Dieser zweite Bereich hat die Form einer Wanne, deren Tiefe d₁ etwa 2,5 µm beträgt, und ist n-dotiert. Die Höhe der Dotierung beträgt an der Grenze zum ersten Bereich 14 etwa 10¹⁵ cm⁻³, nimmt nach unten kontinuierlich zu und erreicht am unteren Ende der Wanne einen Wert von etwa von 10¹⁸ cm⁻³. Dieses Dotierungsprofil ist in Fig. 1 durch die dichter werdende Schraffur angedeutet. Die horizontal verlaufende Grenzfläche zwischen dem ersten und dem zweiten Bereich 14 bzw. 16 bildet den pn-Übergang der Photodiode 18 der Bildzelle. Unterhalb des Bereichs 16 ist eine buried layer 17 angeordnet, wie sie etwa von BipolarTransistoren her bekannt ist. Aufgrund ihrer homogenen und hohen Dotierung von etwa 10¹⁸ cm⁻³ weist diese Schicht 17 eine hohe Leitfähigkeit auf und stellt somit annähernd eine Äquipotentialfläche dar.

An der Oberfläche des Substrats 12 befinden sich außerdem zwei dritte Bereiche 22 und 24. Diese dritten Bereiche sind mit etwa 10²⁰ cm⁻³ p-dotiert und bilden zusammen mit einer Gate-Elektrode 26 und einer darunter liegenden Transistorwanne 28 einen p-Kanal-Transistor 30. Die Transistorwanne 28 ist oberflächennah mit etwa 10¹⁷ cm⁻³ n-dotiert. Nach unten hin nimmt die Dotierung kontinuierlich zu und erreicht am unteren Ende der Wanne einen Wert von annähernd 10¹⁸ cm⁻³. Die Transistorwanne 28 ist weitgehend in den zweiten Bereich 16 eingebettet, unterscheidet sich von jener jedoch durch die Stärke der n-Dotierung, so daß beide Bereiche durch ihre Dotierung voneinander abgegrenzt sind. Grundsätzlich können der zweite Bereich 14 und die Transistorwanne 28 aber auch getrennt voneinander oder so nebeneinander angeordnet sein, daß sie nur entlang einer vertikal verlaufenden Fläche aneinander angrenzen. Die Tiefe d₂ der Transistorwanne 28 beträgt etwa 1,2 µm und ist somit deutlich geringer als die Tiefe d₁ des zweiten Bereichs 16.

Neben dem p-Kanal-Transistor 30 befindet sich ein n-Kanal-Transistor 32, der zwei mit 10²⁰ cm⁻³ n-dotierte Bereiche 34 und 36, eine Gate-Elektrode 38 und eine mit 10¹⁷ cm⁻³ p-dotierte Transistorwanne 40 umfaßt. Der p-Kanal-Transistor 30 ist vom n-Kanal-Transistor 32 durch einen Isolationsbereich 42 elektrisch isoliert. Der Isolationsbereich42 besteht aus einem Polysiliziumkörper 44, der von einer SiO₂-Schicht 46 umschlossen ist. Isolationsbereiche 42 befinden sich außerdem links vom n-Kanal-Transistor 32 und rechts von der Photodiode 18.

Die Oberfläche des Substrats ist überwiegend mit einer primären Isolationsschicht 48 bedeckt, die im Bereich von oberflächennahen Bereichen und der Elektroden unterbrochen ist. Über der primären Isolationsschicht 48-kann eine zusätzliche Passivierungsschicht aufgebracht sein. Möglich ist außerdem, daß sich weitere aktive Halbleiterbauelemente über den Transistoren und der Photodiode in der Art einer sog. Multilayer-Struktur befinden. Es ist lediglich sicherzustellen, daß elektromagnetische Strahlung 50 auf die Photodiode 18 fallen kann. Die über dem ersten Bereich 14 liegenden Schichten müssen also zumindest für die zu detektierenden Wellenlängenbereiche weitgehend durchlässig sein. Nur schematisch angedeutet sind in Fig. 1 eine Mikrolinse 52 und ein Farbfilter 54, die über der Oberfläche der Photodiode 18 angeordnet sein können. Nicht dargestellt ist eine ebenfalls optionale Antireflexionsschicht, die aus einer Schichtenfolge mit wechselndem Brechungsindex besteht und unmittelbar auf dem ersten Bereich 14 aufgebracht ist oder die darüber liegenden Schichten bedeckt.

Am ersten Bereich 14 der Photodiode 18 liegt über einen Kontakt 56 das Diodenpotential U_{d} an. Der zweite Bereich 16 ist im dargestellten Ausführungsbeispiel oberflächennah über einen stark n-dotierten Bereich 58 kontaktiert, an dem das positive Versorgungspotential U_{DD} anliegt. Die Beschaltung der beiden Transistoren 30 und 32 ist in Fig. 1 durch die anliegenden Potentiale gekennzeichnet, wobei U_{SS} das Nullpotential, U_{G} das Gatepotential und Uₛ das Source-Potential bezeichnet. Das Substrat 12 ist über einen unterseitigen Kontakt geerdet. Zwischen dem p-Kanal-Transistor 30 und der Photodiode 18 ist die Transistorwanne 28 oberflächennah noch über einen n-dotierten Bereich 60 mit einem weiteren Kontakt versehen, an dem die positive Betriebsspannung U_{DD} anliegt.

Im folgenden wird die Funktion der erfindungsgemäßen Bildzelle 10 erläutert. Einfallende, elektromagnetische Strahlung 50 wird von der Linse 52 gebündelt. Der Farbfilter 54 filtert aus der Strahlung 50 die nicht gewünschten Wellenlängenanteile heraus. Die verbleibenden Anteile der Strahlung treffen auf den ersten Bereich 14 der Photodiode 18. Die Photodiode 18 ist über die Kontakte 56 und 58 so beschaltet, daß der pn-Übergang zwischen dem ersten und zweiten Bereich 14 bzw. 16 in Sperrichtung gepolt ist. Als Folge dieser Polung bildet sich eine in vertikaler Richtung breite Raumladungszone aus, in der die Dichte an freien Ladungsträgern gering ist. Durch Absorption der einfallenden elektromagnetischen Strahlung werden in der Raumladungszone aus Elektronen und Löchern bestehende Ladungsträgerpaare erzeugt, die durch das elektrische Sperrfeld abgezogen werden und somit zum Photostrom durch die Photodiode beitragen. Aufgrund der großen Tiefe d₁ des zweiten Bereich 16 ist die Raumladungszone bei der erfindungsgemäßen Bildzelle besonders groß. Somit können auch langwellige Strahlungsanteile, die eine größere Eindringtiefe als kurzwellige haben, noch Ladungsträgerpaare im unteren Bereich des zweiten Bereichs 16 erzeugen und somit zum Photostrom beitragen. Dadurch wird die Empfindlichkeit der Bildzelle gesteigert.

Die beiden Transistoren 30 und 32 dienen der Verstärkung oder Umwandlung des Photostroms; deren Verschaltung mit der Photodiode ist allerdings nicht wesentlich für die Erfindung, da derartige Verschaltungen an sich im Stand der Technik bekannt sind, ohne daß es dafür eines besonderen Nachweises bedarf.

Bei der Herstellung der Bildzelle und des Bildsensors wird auf an sich aus der CMOS-Technik bekannte Verfahren zurückgegriffen. Die kontinuierlichen Dotierungsprofile können im Wege der Hochenergieimplantation oder durch sukzessive Implantation erzeugt werden. Eine weitere Möglichkeit zur Erzeugung eines retrograde Wells besteht im sog. Wafer-Bonding. Hierbei wird eine dünne Waferscheibe (Handle-Wafer) zunächst mit einem Profil dotiert, bei dem die Dotierung von oben nach unten abnimmt. Anschließend wird der Handle-Wafer auf den einen Substrat-Wafer aufgebonded. Durch Diffusion bei erhöhter Temperatur wird das Dotierungsprofil des Handle-Wafers umgekehrt auf den Substrat-Wafer übertragen. Nach Ablösen oder Abschleifen des Handle-Wafers weist der Substrat-Wafer das gewünschte retrograde Well auf.

Falls, wie bei dem in Fig. 1 dargestellten Ausführungsbeispiel, eine buried layer vorgesehen ist, so wird diese zunächst als hochdotierter Bereich an der Oberfläche eines Wafers erzeugt. Anschließend werden die darüberliegenden Schichten epitaktisch auf die Oberfläche aufgebracht.

Es versteht sich, daß in den vorstehend beschriebenen Ausführungsbeispielen die p-Dotierungen und n-Dotierungen miteinander vertauscht werden können, sofern die Vorzeichen der anliegenden Potentiale ebenfalls vertauscht werden.

## Patentansprüche

1. In Halbleitertechnik aufgebaute Bildzelle (10) zur Umwandlung von auf eine Oberfläche der Bildzelle auftreffender elektromagnetischer Strahlung (50) in ein elektrisches Signal
a) mit einem Substrat (12), das eine erste Dotierung aufweist und das in mehrere aneinander angrenzende Bereiche (14, 16, 17, 22, 24, 28) mit unterschiedlicher Dotierung unterteilt ist, wobei die Bereiche ein strahlungssensitives Element (18) und ein Halbleiterbauelement (30) bilden,
b) wobei das strahlungssensitive Element (18) einen oberflächennahen ersten Bereich (14) und einen oberflächenfernen zweiten Bereich (16) aufweist, wobei der zweite Bereich (16) dotiert ist und an den ersten Bereich (14) angrenzt, und
c) wobei das Halbleiterbauelement (30) wenigstens einen oberflächennahen, dotierten dritten Bereich (22, 24) und einen oberflächenfernen, dotierten vierten Bereich (28) aufweist,
d) wobei die Ausdehnung (d₁) des zweiten Bereichs (16) in der zur Oberfläche senkrechten Richtung größer ist als die entsprechende Ausdehnung (d₂) des vierten Bereichs (28), und
e) wobei der vierte Bereich (28) wenigstens teilweise in dem zweiten Bereich eingebettet ist und eine höhere gleichartige Dotierung als der zweite Bereich (16) aufweist,
**dadurch gekennzeichnet, daß** der zweite Bereich (16) die Form einer Wanne hat und eine Dotierung aufweist, die entgegengesetzt zu der ersten Dotierung des Substrats (12) ist, so dass der zweite Bereich (16) und das Substrat (12) durch einen pn-Übergang voneinander getrennt sind.

2. Bildzelle nach Anspruch 1, **dadurch gekennzeichnet, daß** der erste Bereich (14) komplementär zu dem zweiten Bereich (16) dotiert ist, so daß der erste und der zweite Bereich den pn-Übergang einer Photodiode (18) bilden.

3. Bildzelle nach einem der vorhergehenden Ansprüche, **dadurch gekennzeichnet, daß** das Halbleiterbauelement ein Transistor (30) und der vierte Bereich (28) eine Transistorwanne ist.

4. Bildzelle nach Anspruch 3, **dadurch gekennzeichnet, daß** oberflächennah zwischen dem Transistor (30) und der Photodiode (18) ein an die Transistorwanne (28) angrenzender Kontakt (56) angeordnet ist.

5. Bildzelle nach einem der vorhergehenden Ansprüche, **dadurch gekennzeichnet, daß** der zweite Bereich (16) mit wenigstens einem elektrischen Kontakt (58) versehen ist, um den pn-Übergang zwischen dem zweiten Bereich (16) und dem Substrat (12) in Sperrichtung zu polen.

6. Bildzelle nach einem der Ansprüche 1 bis 5, **dadurch gekennzeichnet, daß** in der zur Oberfläche senkrechten Richtung die Ausdehnung des ersten Bereichs (14) zwischen etwa 0,1 *µ*m und 0,2 *µ*m und die Ausdehnung (d₁) des zweiten Bereichs (16) zwischen etwa 2 *µ*m und 3 *µ*m liegt.

7. Bildzelle nach einem der Ansprüche 1 bis 5, **dadurch gekennzeichnet, daß** in der zur Oberfläche senkrechten Richtung die Ausdehnung des ersten Bereichs (14) zwischen etwa 0,8 µm und 0,9 µm liegt und die Ausdehnung (d₁) des zweiten Bereichs (16) etwa 8 µm beträgt.

8. Bildzelle nach einem der Ansprüche 1 bis 7, **dadurch gekennzeichnet, daß** die Dotierung des ersten Bereichs (14) in der Größenordnung von etwa 10¹⁸ cm⁻³ liegt.

9. Bildzelle nach einem der vorhergehenden Ansprüche, **dadurch gekennzeichnet, daß** die Dotierung wenigstens in dem zweiten (14) oder in dem vierten Bereich (16) mit zunehmendem Abstand von der Oberfläche größer wird.

10. Bildzelle nach einem der Ansprüche 8 oder 9, **dadurch gekennzeichnet, daß** die Dotierung des zweiten Bereichs (16) oberflächennah in der Größenordnung von etwa 10¹⁵ cm⁻³ und oberflächenfern in der Größenordnung von etwa 10¹⁸ cm⁻³ liegt.

11. Bildzelle nach einem der vorhergehenden Ansprüche, **dadurch gekennzeichnet, daß** über der Oberfläche der Bildzelle eine Mikrolinse (52) angeordnet ist.

12. Bildzelle nach einem der vorhergehenden Ansprüche, **dadurch gekennzeichnet, daß** über der Oberfläche der Bildzelle ein Farbfilter (54) angeordnet ist.

13. Bildzelle nach einem der vorhergehenden Ansprüche, **dadurch gekennzeichnet, daß** über der Oberfläche der Bildzelle eine Antireflexionsschicht angeordnet ist.

14. Bildzelle nach einem der vorhergehenden Ansprüche, **dadurch gekennzeichnet, daß** an die oberflächenferne Seite des zweiten Bereichs (16) eine buried layer (17) angrenzt.

15. Bildsensor (170) mit einer Vielzahl nebeneinander angeordneter Bildzellen (130a, 112a; 130b, 112b; 130c, 112c) nach einem der vorhergehenden Ansprüche.

16. Verfahren zur Herstellung einer Bildzelle mit folgenden Schritten:
a) Bereitstellen eines Halbleitersubstrats (12) mit einer ersten Dotierung,
b) Erzeugen eines oberflächenfernen dotierten zweiten Bereichs (16) im Halbleitersubstrat,
c) Erzeugen eines oberflächenfernen, dotierten vierten Bereichs (28),
d) Erzeugen eines oberflächennahen ersten Bereichs (14), der an den zweiten Bereich angrenzt,
e) Erzeugen eines oberflächennahen dotierten dritten Bereichs (22, 24), der an den vierten Bereich angrenzt,
f) wobei der erste (14) und zweite (16) Bereich derart erzeugt werden, daß sie ein strahlungssensitives Element (18) bilden,
g) wobei der dritte (22, 24) und vierte Bereich (28) derart erzeugt werden, daß sie ein Halbleiterbauelement (30) bilden,
h) wobei der vierte Bereich (28) mit einer senkrecht zur Oberfläche kleineren Ausdehnung (d₂) als die entsprechende Ausdehnung (d₁) des zweiten Bereichs (16) erzeugt wird, und
i) wobei der vierte Bereich (28) wenigstens teilweise in den zweiten Bereich (16) eingebettet wird und mit einer höheren gleichartigen Dotierung als der zweite Bereich (16) erzeugt wird,
**dadurch gekennzeichnet, daß** der zweite Bereich (16) die Form einer Wanne erhält und mit einer Dotierung erzeugt wird, die entgegengesetzt zu der ersten Dotierung des Substrates (12) ist, so dass der zweite Bereich (16) und das Substrat (12) durch einen pn-Übergang voneinander getrennt werden.

## Claims

1. An image cell (10) constructed using semiconductor technology and serving for converting electromagnetic radiation (50) impinging on a surface of the image cell into an electrical signal,
a) comprising a substrate (12) which has a first doping and is subdivided into a plurality of adjoining regions (14, 16, 17, 22, 24, 28) having different dopings, wherein the regions form a radiation-sensitive element (18) and a semiconductor element (30),
b) wherein the radiation-sensitive element (18) has a first region (14) near the surface and a second region (16) remote from the surface, the second region (16) being doped and adjoining the first region (14) and
c) wherein the semiconductor element (30) has at least one doped third region (22, 24) near the surface and a doped fourth region (28) remote from the surface,
d) wherein the extent (d₁) of the second region (16) in the direction perpendicular to the surface is greater than the corresponding extent (d₂) of the fourth region (28), and
e) wherein the fourth region (28) is at least partly embedded in the second region and has a higher doping of the same type than the second region (16),
**characterized in that** the second region (16) is in the form of a well and has a doping which is opposite to the first doping of the substrate (12), so that the le second region (16) and the substrate (12) are separated from one another by a pn junction.

2. The image cell according to Claim 1, **characterized in that** the first region (14) is doped complementarily with respect to the second region (16), so that the first and second regions form the pn junction of a photodiode (18).

3. The image cell according to any of the preceding claims, **characterized in that** the semiconductor element is a transistor (30) and the fourth region (28) is a transistor well.

4. The image cell according to Claim 3, **characterized in that** a contact (56) adjoining the transistor well (28) is arranged near the surface between the transistor (30) and the photodiode (18).

5. The image cell according to any of the preceding claims, **characterized in that** the second region (16) is provided with at least one electrical contact (58) in order to bias the pn junction between the second region (16) and the substrate (12) in reverse direction.

6. The image cell according to any of Claims 1 to 5, **characterized in that**, in the direction perpendicular to the surface, the extent of the first region (14) is between about 0.1 µm and 0.2 µm, and the extent (dl) of the second region (16) is between about 2 µm and 3 µm.

7. The image cell according to any of Claims 1 to 5, **characterized in that**, in the direction perpendicular to the surface, the extent of the first region (14) is between about 0.8 µm and 0.9 µm and the extent (d₁) of the second region (16) is about 8 µm.

8. The image cell according to any of Claims 1 to 7, **characterized in that** the doping of the first region (14) is of the order of magnitude of about 10¹⁸ cm⁻³.

9. The image cell according to any of the preceding claims, **characterized in that** the doping at least in the second (14) or in the fourth region (16) increases with increasing distance from the surface.

10. The image cell according to either of Claims 8 or 9, **characterized in that** the doping of the second region (16) is of the order of magnitude of about 10¹⁵cm⁻³ near the surface and of the order of magnitude of about 10¹⁸ cm⁻³ remote from the surface.

11. The image cell according to any of the preceding claims, **characterized in that** a microlens (52) is arranged above the surface of the image cell.

12. The image cell according to any of the preceding claims, **characterized in that** a colour filter (54) is arranged above the surface of the image cell.

13. The image cell according to any of the preceding claims, **characterized in that** an antireflection layer is arranged above the surface of the image cell.

14. The image cell according to any of the preceding claims, **characterized in that** a buried layer (17) adjoins that side of the second region (16) which is remote from the surface.

15. The image sensor (170) having a plurality of image cells (130a, 112a; 130b, 112b; 130c, 112 c) according to any of the preceding claims, which image cells are arranged next to one another.

16. A method for fabricating an image cell comprising the following steps:
a) providing a semiconductor substrate (12) having a first doping
b) producing a doped second region (16) remote from the surface in the semiconductor substrate,
c) producing a doped fourth region (28) remote from the surface,
d) producing a first region (14) near the surface, which region adjoins the second region,
e) producing a doped third region (22, 24) near the surface, which region adjoins the fourth region,
f) wherein the first (14) and second (16) regions are produced in such a way that they form a radiation-sensitive element (18),
g) wherein the third (22, 24) and fourth regions (28) are produced in such a way that they form a semiconductor element (30),
h) wherein the fourth region (28) is produced with an extent (d₂) which perpendicular to the surface, is smaller than the corresponding extent (d₁) of the second region (16), and
i) wherein the fourth region (28) is at least partly embedded in the second region (16) and is produced with a higher doping of the same type than the second region (16),
**characterized in that** the second region (16) is produced in the form of a well and with a doping which is opposite to the first doping of the substrate (12), so that the second region (16) and the substrate (12) are separated from one another by a pn junction.

## Revendications

1. Cellule capteur d'image (10) construite en technique de semi-conducteur pour la conversion d'un rayonnement électromagnétique (50) incident sur une surface d'une cellule capteur d'image dans un signal électrique
a) avec un substrat (12) qui comporte un premier dopage et qui est réparti en plusieurs zones adjacentes les unes aux autres (14, 16, 17, 22, 24, 28) avec dopage différent, les zones formant un élément sensible au rayonnement (18) et un composant de semi-conducteur (30).
b) sachant que l'élément sensible au rayonnement (18) présente une première zone près de la surface (14) et une deuxième zone loin de la surface (16), la deuxième zone (16) étant dopée et adjacente à la première zone (14), et
c) sachant que le composant de semi-conducteur (38) comporte au moins une troisième zone dopée près de la surface (22, 24) et une quatrième zone dopée loin de la surface (28),
d) sachant que l'extension (d₁) de la deuxième zone (16) dans le sens perpendiculaire à la surface est supérieure à l'extension correspondante (d₂) de la quatrième zone (28), et
e) sachant que la quatrième zone (28) est encastrée au moins partiellement dans une deuxième zone et comporte un dopage similaire plus élevé que la deuxième zone (16),
**caractérisée en ce que** la deuxième zone (16) a la forme d'une cuve et comporte un dopage qui, contrairement au premier dopage du substrat (12) est tel que la deuxième zone (16) et le substrat (12) sont séparés l'un de l'autre par une transition pn.

2. Cellule capteur d'image selon la revendication 1, **caractérisé en ce que** la première zone (14) est dopée en complément à la deuxième zone (16) de telle manière que la première zone et la deuxième zone forment la transition pn d'une photodiode (18).

3. Cellule capteur d'image selon l'une des revendications précédentes, **caractérisée en ce que** l'élément de semi-conducteur est un transistor (30) et la deuxième zone (28) une cuve de transistor.

4. Cellule capteur d'image selon la revendication 3, **caractérisée en ce qu'**un contact (56) touchant la cuve de transistor (28) est disposé près de la surface entre le transistor (30) et la photodiode (18).

5. Cellule capteur d'image selon l'une des revendications précédentes, **caractérisée en ce que** la deuxième zone (16) est équipée au moins d'un contact électrique (58) pour polariser la transition pn entre la deuxième zone (16) et le substrat (12) dans le sens de non-conduction.

6. Cellule capteur d'image selon l'une des revendications 1 à 5, **caractérisée en ce que** l'extension de la première zone (14) dans le sens perpendiculaire à la surface est entre 0,1 µm et 0,2 µm et l'extension (d₁) de la deuxième zone (16) est entre 2 µm et 3 µm.

7. Cellule capteur d'image selon l'une des revendications 1 à 5, **caractérisée en ce que** l'extension de la première zone (14) dans le sens perpendiculaire à la surface est entre 0,8 µm et 0,9 µm et l'extension (d₁) de la deuxième zone (16) est entre 8 µm et 3 µm.

8. Cellule capteur d'image selon l'une des revendications 1 à 7, **caractérisée en ce que** le dopage de la première zone (14) est de l'ordre d'environ : 10¹⁸ cm⁻³.

9. Cellule capteur d'image selon l'une des revendications précédentes, **caractérisée en ce que** le dopage au moins dans la deuxième (14) ou la quatrième zone (16) est supérieur avec un intervalle croissant depuis la surface.

10. Cellule capteur d'image selon l'une des revendications 8 ou 9, **caractérisée en ce que** le dopage de la deuxième zone (16) est de l'ordre d'environ 10¹⁵ cm⁻⁵ près de la surface et de l'ordre d'environ 10¹⁶ cm⁻³ loin de la surface.

11. Cellule capteur d'image selon l'une des revendications précédentes, **caractérisée en ce qu'**une microlentille (52) est disposée sur la surface de la cellule capteur.

12. Cellule capteur d'image selon l'une des revendications précédentes, **caractérisée en ce qu'**un filtre coloré (54) est disposé sur la surface de la cellule capteur.

13. Cellule capteur d'image selon l'une des revendications précédentes, **caractérisée en ce qu'**une couche antireflet est disposée sur la surface de la cellule capteur.

14. Cellule capteur d'image selon l'une des revendications précédentes, **caractérisée en ce qu'**une couche enterrée (17) touche le côté éloigné de la surface de la deuxième zone (16).

15. Capteur d'image (170) avec un grand nombre de cellules capteur d'image disposées les unes à côté des autres (130a, 130b, 112b, 130c, 112c) selon l'une des revendications précédentes.

16. Procédé de fabrication d'une cellule capteur d'image avec les étapes suivantes :
a) Préparation d'un substrat de semi-conducteur (12) avec un premier dopage,
b) production d'une deuxième zone dopée loin de la surface (16) dans le substrat du semi-conducteur
c) production d'une quatrième zone (28) dopée loin de la surface,
d) production d'une première zone (14) près de la surface, qui touche la deuxième zone,
e) production d'une troisième zone dopée (22,24) près de la surface, qui touche la quatrième zone,
f) sachant que la première zone (14) et la deuxième zone (16) sont produites de telle manière qu'elles forment un élément (18) sensible au rayonnement.
g) sachant que la troisième zone (22, 24) et la quatrième zone (28) sont produites de telle manière qu'elles forment un composant de semi-conducteur (30),
h) sachant que la quatrième zone (28) est produite avec une extension (d₂) perpendiculaire à la surface plus petite que l'extension (d₁) correspondante de la deuxième zone (16), et
i) sachant que la quatrième zone (28) est encastrée au moins partiellement dans la deuxième zone (16) et est produite avec un dopage identique plus élevé que la deuxième zone (16),
**caractérisé en ce que** la deuxième zone (16) a la forme d'une cuve et est produite avec un dopage qui, contrairement au premier dopage du substrat (12) est tel que la deuxième zone (16) et le substrat (12) sont séparés l'un de l'autre par une transition.
